# EUROPÄISCHE PATENTSCHRIFT

(11) **EP 1 873 915 B1**
(45) Veröffentlichungstag und Bekanntmachung des Hinweises auf die Patenterteilung: **16.04.2014**
(21) Anmeldenummer: 07011577.9
(22) Anmeldetag: 13.06.2007
(51) Int. Cl.: H03K 5/24, H03K 19/007

(54) **Sichere Eingangsschaltung mit einkanaligem Peripherieanschluss für den Eingang eines Busteilnehmers**
Secure input circuit with single channel peripheral connection for the input of a bus participant
Circuit d'entrée sécurisé doté d'un raccordement périphérique sur un canal unique pour l'entrée d'un utilisateur de bus

(30) Priorität: 28.06.2006 DE 102006030114
(43) Veröffentlichungstag der Anmeldung: 02.01.2008
(60) Teilanmeldung: 11005739.5
(73) Patentinhaber: Phoenix Contact GmbH & Co. KG, 32825 Blomberg (DE)
(72) Erfinder: Oster, Viktor, 32825 Blomberg (DE)
(74) Vertreter: Blumbach Zinngrebe

(56) Entgegenhaltungen:
- EP-A- 0 393 282
- DE-A1- 19 906 932
- GB-A- 2 136 233
- JP-A- 1 237 702
- JP-A- 3 004 308
- JP-A- 4 244 778
- "TL431, TL431A, Adjustable Precision Shunt Regulators" TEXAS INSTRUMENTS DATA SHEET, Oktober 2000 (2000-10), Seiten 1-18, XP002453098

## Beschreibung

Die Erfindung betrifft eine Eingangsschaltung für eine Eingangsbaugruppe, insbesondere eine Bus-Eingangsbaugruppe, zum sicheren Einlesen von an der Eingangsbaugruppe anliegenden Eingangssignalen.

Zum Einlesen von Informationen aus einer Prozessumgebung, wie beispielsweise aus einem Feld, durch über entsprechend angeordnete Signalgeber bereitgestellte Eingangssignale also insbesondere durch Schalter, Sensoren, werden Anforderungen an die Fehlererkennung und das Ausfallverhalten einer hierzu aufgebauten Schaltung sowie der Peripherie gestellt.

Insbesondere bei sicherheitsrelevanten Informationen auf dem Gebiet der Sicherheitstechnik müssen diese beispielsweise Standards gemäß DIN EN 954-1 oder nach IEC 61508 genügen. Zum Erfüllen derartiger Anforderungen sind komplexe, herkömmlicherweise zweikanalige Strukturen der Eingangsschaltung erforderlich, was einen erhöhten Aufwand in der Schaltungsrealisierung und in der Beschaltung der Peripherie bedeutet, also insbesondere in Bezug auf die Verdrahtung zum Signalgeber, beispielsweise zu einem Sicherheitsschalter. Derartige Schaltungen sind somit sehr komplex aufgebaut und folglich auch kostenintensiv. Durch den erhöhten Bedarf an Bauelementen sind diese Schaltungen ferner noch nachteilig in Bezug auf deren Verfügbarkeit.

Das Dokument DE 199 06 932 A1 zeigt eine Schaltung mit einer Referenzspannungsquelle und einem Eingabekanal, Über eine externe Testschaltung kann die Funktionsfähigkeit eines Eingabekanals in einem Testzyklus überprüft werden.

Eine Aufgabe der Erfindung ist es, eine gegenüber dem Stand der Technik neue und wesentlich einfachere Schaltung zum Einlesen von sicherheitsrelevanten Signalen bereitzustellen.

Die erfindungsgemäße Aufgabe wird durch eine Eingangsschaltung nach Anspruch 1 gelöst. Vorteilhafte und/oder bevorzugte Ausführungsformen, Weiterbildungen, Verwendungen und/oder eine solche Einschaltungsschaltung einsetzende oder umsetzende bzw. unterstützende Einrichtungen sind Gegenstand der weiteren Ansprüche.

Eine erfindungsgemäße Eingangsschaltung für eine Eingangsbaugruppe, insbesondere eine Bus-Eingangsbaugruppe, zum sicheren Einlesen von an der Eingangsbaugruppe anliegenden Eingangssignalen, welche insbesondere den Standards Kat, 4 DIN EN 954 und SIL 3 IEC 61508 genügt, zeichnet sich durch wenigstens einen Signaleingangsschaltkreis mit einkanaligem Peripherieanschluss zum Anschließen wenigstens eines Signalgebers aus, sowie durch einen mit dem Signaleingangsschaltkreis über ein erstes Koppelglied elektrisch anschaltbaren Auswertekreis und einen mit dem Signaleingangsschaltkreis elektrisch verbundenen Schaltkreis, im Folgenden als "Vergleichsschaltkreis" bezeichnet, zum Einstellen einer Referenzspannung zum Aktivieren und Deaktivieren des Koppelgliedes.

Zur Umsetzung einer solchen erfindungsgemäßen Eingangsschaltung schlägt die Erfindung somit ferner einen Vergleichsschaltkreis für einen Signaleingangsschaltkreis einer Eingangsbaugruppe, insbesondere einer Bus-Eingangsbaugruppe, mit einkanaligem Peripherieanschluss zum Anschließen wenigstens eines Signalgebers vor, wobei der Signaleingangsschaltkreis zum Einlesen von an der Eingangsbaugruppe anliegenden Eingangssignalen über ein erstes Koppelglied an einen Auswertekreis elektrisch anschaltbar ist, und wobei der Vergleichsschaltkreis zum sicheren Einlesen der Eingangsignale Mittel zum Einstellen einer Referenzspannung zum Aktivieren und Deaktivieren des Koppelgliedes umfasst.

Die Erfindung ermöglicht somit durch den Vergleichsschaltkreis das anwendungsspezifische Setzen von Schaltschwellen zwischen dem Signaleingangskreis und dem Auswertekreis, so dass auch die Sicherheitsanforderungen nach Kategorie 4 DIN EN 954 und SIL 3 IEC 61508 erfüllt werden können, wobei der Signaleingangsschaltkreis für eine sichere Eingangsschaltung zur Peripherie hin trotzdem einkanalig ausgelegt ist und somit aus wenigen Bauteilen kosteneffizient und mit wesentlich verbesserten Zeiten zwischen dem Auftreten von Fehler, sogenannten MTBF (mean time between failures)-Zeiten und folglich gesteigerter Verfügbarkeit aufbaubar ist.

Der Vergleichsschaltkreis umfasst eine Referenzspannungsquelle und eine Schaltung zum Testen der Referenzspannungsquelle. Hierdurch kann der Vergleichsschaltkreis selbst getestet und eine zur geforderten Sicherheit notwendige Schaltschwelle der Eingangssignale auf einfache Weise sichergestellt und verifiziert werden,

Zur weiteren Steigerung der Sicherheit gegenüber Bauteilausfällen, weist die Testschaltung zwei, aus drei Widerständen aufgebaute, an einer Referenzdiode angeschaltete Spannungsteiler zum Einstellen der Referenzspannung aufweist.

Jeder der Spannungsteiler ist an ein jeweiliges zweites Koppelglied zum jeweils individuellen Aufprägen eines Stromflusses angeschlossen. Hierdurch sind im Wesentlichen alle kritischen Bauteile der Vergleichsschaltung und des Signaleingangsschaltkreises sowie das Koppelglied testbar.

Die Referenzdiode ist an eine Versorgungsspannung angeschaltet, wobei zur Begrenzung der Versorgungsspannung für die Referenzdiode ein im Leiter zwischen Referenzdiode und Versorgungsspannung angeordneter Widerstand und eine parallel zur Referenzdiode geschaltete Z-Diode vorgesehen sind.

Die Eingangsschaltung umfasst ferner eine im Signaleingangsschaltkreis geschaltete Z-Diode zur Begrenzung der auf einem anliegenden Eingangssignal basierenden Eingangsspannung auf einen Maximalwert. Nachfolgende Bauteile können somit insgesamt für geringere Spannungen ausgelegt werden.

Um ein Testen des zwischen Signaleingangskreises und Auswertekreises angeordneten Koppelgliedes ferner unabhängig von dem Vergleichsschaltkreis zu gewährleisten, welche eine nochmals erhöhte Sicherheit bietet, umfasst eine erfindungsgemäße Eingangsschaltung ferner eine mit dem Signaleingangsschaltkreiskreis elektrisch verbundene Testschaltung zum Testen des ersten Koppelgliedes.

In besonders einfacher weise ist dabei vorgesehen, dass die Testschaltung zum Testen des ersten Koppelgliedes ein drittes Koppelglied aufweist, über welches eine Testspannung an das erste Koppelglied in dem Signaleingangsschaltkreis anlegbar ist.

Um eine Entkopplung verschiedener Spannungsbereiche zu gewährleisten, ist in weiterer bevorzugter Ausbildung wenigstens das erste Koppelglied ein Optokoppler, besonders bevorzugt sind alle Koppelglieder Optokoppler.

Eine nochmals erhöhte Sicherheit stellt sich ein, wenn der Auswertekreis zweikanalig aufgebaut ist.

Von Vorteil ist ferner, dass redundante Signalgeber in Reihe an den Signaleingangsschaltkreis schaltbar sind. Da der Signaleingangsschaltkreis für den redundanten Kanal somit vollständig entfällt, verbessert sich zum Einen nochmals die Verfügbarkeit und zum Anderen wird der Verdrahtungsaufwand weiter reduziert, da folglich auch bei der Verwendung von redundanten Signalgebern, wie z.B. Sicherheitsschaltern, weiterhin nur eine Klemme erforderlich ist.

Von weiterem Vorteil ist, dass eine Vielzahl von Signaleingangsschaltkreisen an den Vergleichsschaltkreis parallel anschaltbar ist, da somit bereits ein Vergleichsschaltkreis für eine Vielzahl von Eingangskreises ausreichend ist.

Die erfindungsgemäße Schaltung ist somit bevorzugt in der Sicherheitstechnik zum Einlesen von sicherheitsrelevanten Sensorsignalen verwendbar und/oder innerhalb einer Buseingangsbaugruppe integriert, welche Teil eines Masters, einer sicheren Steuerung und/oder einer Feldeinheit ist. Die Schaltung gewährleistet hierbei einen einkanaligen Aufbau im Peripheriebereich hin zu einer zweikanaligen Auswertung im Logikbereich, wodurch die Herstellungskosten sowie der Platzbedarf deutlich reduziert werden. Ferner kann im wesentlichen die komplette Schaltung mit einfachen Mitteln sowie die Schaltwellen zu 100% getestet werden. Diese Schaltung kann neben einem Erfassen von sicheren Signalen ferner zum Erfassen von Standard-Signalen, insbesondere wenn erhöhte Anforderungen bestehen, verwendet werden.

Die Erfindung wird nachfolgend anhand einer bevorzugten Ausführungsform unter Bezugnahme auf die beigefügte Zeichnung näher beschrieben, wobei in der Zeichnung

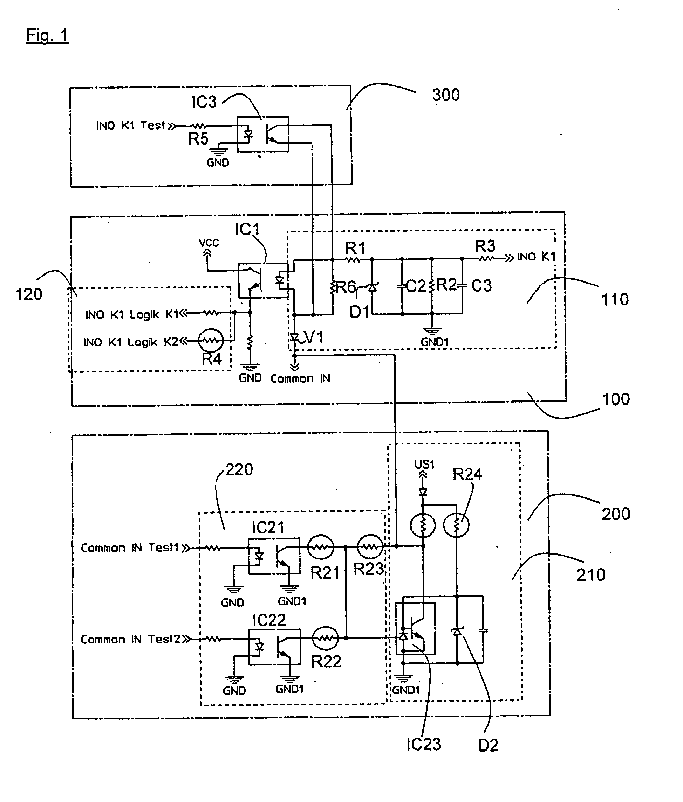

Fig. 1 eine beispielhafte Struktur einer erfindungsgemäßen sicheren Eingangsschaltung darstellt.

Die erfindungsgemäße Eingangsschaltung gemäß Fig. 1 umfasst einen Eingangskreis 100, der im Wesentlichen durch einen Signaleingangsschaltkreis 110 und einen mit dem Signaleingangsschaltkreis 110 über ein Koppelglied IC1 elektrisch anschaltbaren Auswertekreis 120 aufgebaut ist. Der Signaleingangsschaltkreis besitzt einen einkanaligen Peripherieanschluss "INO K1" zum Anschließen wenigstens eines Signalgebers, wie z.B. einen Sensor oder Schalter. Die Eingangsschaltung umfasst ferner einen mit dem Signaleingangsschaltkreis 100 elektrisch verbundenen Vergleichsschaltkreis 200 mit testbarer Referenzspannungsquelle 210 und eine Testschaltung 300 für das Koppelglied IC1.

Die Verbindung zwischen dem Vergleichsschaltkreis 200 und dem Eingangskreis 100 erfolgt über den Signaleingangsschaltkreis 110 an einem mit "COMMON IN" bezeichneten Anschlusspunkt, an welchem durch den Vergleichsschaltkreis 200 eine Referenzspannung zum Aktivieren oder Deaktivieren des Koppelglieds IC1 eingestellt werden kann.

Da über den gemeinsamen Anschlusspunkt "COMMON IN" weitere Eingangskreise anschließbar sind, ist ein erstes wesentliches Merkmal der erfindungsgemäßen Eingangsschaltung somit, dass der Vergleichsschaltkreis 200 nur einmal vorhanden sein muss, um auch mehrere Eingangskreise zu bedienen. Da solche weiteren Eingangskreise zweckmäßiger Weise entsprechend dem Eingangskreis 100 aufgebaut sind, beschränkt sich die nachfolgende Beschreibung auf die in Fig. 1 dargestellte Ausführungsform und ist auf solche weiteren Eingangskreise übertragbar.

Das Koppelglied IC1 ist zur galvanischen Trennung des Auswertekreises 120 vom Signaleingangsschaltkreis 110 ein Optokoppler, welchem auf der Primärseite zur Strombegrenzung ein Widerstand R1 vorgeschaltet ist. Der dargestellte Signaleingangsschaltkreis 110 weist beispielhaft einen aus Widerständen R2 und R3 aufgebauten Spannungsteiler für ein am Eingang des Peripherieanschlusses "INO K1" anliegendes Eingangssignal auf sowie zwei Kondensatoren C2 und C3 zur Kompensation von parasitären Effekten. Es sei darauf hingewiesen, das diesbezüglich grundsätzlich auch eine andere Schaltung als dargestellt umfasst sein kann.

Ferner umfasst der Signaleingangsschaltkreis 110 eine Z-Diode D1 zur letztendlichen Begrenzung einer am Eingang des Peripherieanschluss "INO K1" anliegenden Eingangsspannung im High-Zustand auf einen vorbestimmten maximalen High-Zustands-Eingangsspannungswert sowie eine dem Optokoppler IC1 auf der Primärseite nachgeschaltete Diode V1 zum Schutz des Optokopplers gegen negative Spannung.

Die Sekundärseite des Optokopplers IC1 ist mit einer Spannungsversorgung VCC und dem Auswertekreis 200 verbunden. Im Beispiel gemäß Fig. 1 ist der Auswertekreis 200 zum nicht dargestellten weiteren Logikbereich auf zwei Kanäle "INO K1 Logik K1" und "INO K1 LOGIK K2" aufgeteilt, so dass die einkanalig anliegenden Eingangssignale im Logikbereich auch zweikanalig bearbeitet werden können, welches die Sicherheit in Bezug auf die Auswertung erhöht, jedoch anwendungsspezifisch nicht zwingend erforderlich sein muss. Der dem Kanal "INO K1 LOGIK K2" zugeordnete Widerstand ist hierbei als gewendelter Widerstand dargestellt, so dass eine Entkopplung der beiden Kanäle gegen Überspannung und somit Rückkopplungsfreiheit gewährleistet ist.

Der gemäß Fig. 1 dargestellte Vergleichsschaltkreis 200 umfasst eine Testschaltung 220, welche zwei, aus drei Widerständen R21, R22, R23 aufgebaute Spannungsteiler aufweist, welche an der Referenzdiode IC23 einer Referenzspannungsquelle 210 angeschaltet sind. Ein im Leiter zwischen der Referenzdiode IC23 und einer Versorgungsspannung US1 angeordneter Widerstand R24 und eine parallel zur Referenzdiode geschaltete Z-Diode D2 begrenzen die Versorgungsspannung US1 für die Referenzdiode IC23 auf einen vorbestimmten Wert. Die Widerstände R21, R22, R23 und R24 sind ebenfalls als gewendelte Widerstände dargestellt.

Durch die Spannungsteiler R23 und R21 bzw. R23 und R22 an der Referenzdiode IC23 plus Vorwärtsspannung der Diode V1 und des Optokopplers IC1 wird durch eine am Anschlusspunkt "COMMON IN" anliegende Referenzspannung eine untere Schaltschwelle der Eingangsspannung eingestellt. Dadurch ist sichergestellt, dass der Eingang erst ab einer Eingangsspannung die größer als die vorgegebene Schaltschwellenspannung ist, als gesetzt erkannt werden kann.

Die gemäß Fig. 1 dargestellte Testschaltung 300 zum Testen des Optokopplers IC1 umfasst einen Optokoppler IC3, über welchen eine Testspannung an den Optokoppler IC1 anlegbar ist. Ein Test zur Prüfung der Funktionsfähigkeit des Optokopplers IC1 wird zweckmäßig durchgeführt, wenn ein an "INO K1" anliegendes Eingangssignal im High-Zustand ist oder vom Low-Zustand in den High-Zustand wechselt, der High-Zustands-Eingangsspannungswert somit größer als die Schaltschwellenspannung ist/wird und der Auswertekreis 120 im Normalbetrieb den Eingang folglich als gesetzt erkennt. Bei Anlegen eines Testsignals "INO K1 TEST" an den Optokoppler IC3 wird dann der Optokoppler IC1 gemäß der in Fig. 1 dargestellten Beschaltung überbrückt und mittels geeigneter Dimensionierung der dem Optokoppler IC3 vor- und nachgeschalteten Widerstände R5 bzw. R6 eine Testspannung an den Optokoppler IC1 anlegt, bei welcher der Auswertekreis 120 bei fehlerfreiem Betrieb den Eingang als nicht gesetzt erkennt.

Beim Vergleichsschaltkreis 200 besitzen ferner insbesondere die Widerstände R23, R21 und R22 eine besondere Bedeutung. Da über sie die minimale Eingangsschaltschwelle sicherzustellen ist, ist die Eingangsschaltung an dieser Stelle zur Erhöhung der Sicherheit bevorzugt redundant aufgebaut. Jeder der Spannungsteiler bestehend aus R23 und R21 bzw. R23 und R22 ist über einen Optokoppler IC21 bzw. IC22 zum jeweils individuellen Aufprägen eines Stromflusses an einen mit "COMMON IN TEST1" bzw. "COMMON IN TEST2" bezeichneten Leitungsweg angeschlossen. Durch die redundante Ausführung können überdies die Spannungsteiler R23 und R21 bzw. R23 und R22, die Optokoppler IC21, IC22 sowie die Referenzdiode IC23 vollständig getestet werden. Ferner ist zusätzlich der Optokoppler IC1 testbar.

Nachfolgend werden verschiedene Zustände der Vergleichsschaltung 200 und entsprechende Fehlererkennungen beim Durchführen von Tests beschrieben.

Die Tests werden zweckmäßiger Weise ebenfalls durchgeführt, wenn das an "INO K1" anliegende Eingangssignal im High-Zustand ist, der High-Zustands-Eingangsspannungswert somit größer als die Schaltschwellenspannung ist und der Auswertekreis 120 im Normalbetrieb den Eingang folglich als gesetzt erkennt.

Die beiden Spannungsteiler R23 und R21 bzw. R23 und R22 werden nacheinander eingeschaltet und das Ergebnis auf der Logikseite, d.h. die Signale der Kanäle "IN0 K1 Logik K1" und "IN0 K1 Logik K2" des Auswertekreises 120 verglichen.

Bei fehlerfreiem Betrieb ist die vorgegebene Schaltschwelle der Eingangsschaltung zum Erfassen des an der Eingangsklemme bzw. dem Peripherieanschlusses INO angeschlossenen Eingangs im High-Zustand dann korrekt eingestellt, wenn nur einer der beiden Optokoppler IC21 und IC22, gesetzt ist.

Anschließend werden beide Optokoppler IC21 und IC22 gesetzt, wodurch die Referenzspannung am Anschlusspunkt "COMMON IN" bei fehlerfreiem Betrieb auf eine vorbestimmte Spannung oberhalb des durch die Z-Diode D1 vorbestimmten maximalen High-Zustands-Eingangsspannungswerts angehoben wird. Da die Eingangspannung durch die Z-Diode D1 somit auf einen Wert unterhalb der Schaltschwellenspannung begrenzt wird, fließt kein Strom mehr durch den Optokoppler IC1. In diesem Zustand sind, wenn kein Fehler vorliegt, die Logiksignale der Kanäle "IN0 K1 Logik K1" und "IN0 K1 Logik K2" des Auswertekreises im Low-Zustand.

Begrenzt die Z-Diode D1 z.B. den maximalen High-Zustands-Eingangsspannungswerts auf 8,2V und liegt, wenn nur einer der Optokoppler IC21 und IC22 gesetzt ist, die eingestellte Spannung im Anschlusspunkt "COMMON IN" bei 4,85 Volt, fließt bei einem im High-Zustand befindlichen Eingang Strom durch den Optokoppler IC1 bei fehlerfreiem Betrieb und der Auswertekreis 120 erkennt den Eingang als gesetzt. Die zwei möglichen Zustände, dass nur einer der Optokoppler IC21 und IC22 gesetzt ist, werden ferner benutzt, um die Widerstände R23, R21 und R22 und die Optokoppler IC21 und IC22 zu überprüfen, indem die Optokoppler IC21 und IC22 im Wechsel angesteuert werden. Sind beide Optokoppler IC21 und IC22 gesetzt, beträgt die eingestellte Spannung im Anschlusspunkt "COMMMON IN" beispielsweise 8,47 Volt. Dieser Zustand wird folglich insbesondere auch benutzt, um die Z-Diode D1 und die Rückkopplung des Eingangs zu überprüfen.

Somit wird durch die erfindungsgemäße Eingangschaltung zum einen der Optokoppler IC1 und der Eingangskreis 100 insgesamt mit zwei unterschiedlichen Verfahren und gleichzeitig der Vergleichsschaltkreis 200 getestet und es werden im wesentlichen alle kritischen Fehler aufgedeckt, wobei der sichere Zustand der Schaltung der Low-Zustand ist.

Die erfindungsgemäße Eingangsschaltung gemäß Fig. 1 bietet somit eine einfach realisierbare Möglichkeit die einkanalig am Peripherieanschluss "INO K1" anliegende Eingangsinformation eines Eingangskreises zur Auswertung auf zwei Kanäle zu übertragen. Obwohl die Schaltung im Peripheriebereich somit nur einkanalig realisiert ist, deckt sie die Anforderungen an zweikanalige Systeme nach DIN EN 61508 und DIN EN 954 ab. Sie benötigt folglich nur eine Anschlussklemme zum Anschluss externer Sensoren, wie z.B. Sicherheitsschalter, was den Verdrahtungsaufwand reduziert, wobei redundante Schalter/Sensoren bei entsprechend gefordertem Einsatz in Reihe geschaltet werden können, welches den Verdrahtungsaufwand nochmals wesentlich reduziert. Die erfindungsgemäße Schaltung eignet somit bevorzugt zum Erfassen von sicherheitsrelevanten Signalen an einer Eingangsbaugruppe und ist ferner bevorzugt innerhalb einer nicht näher dargestellten Eingangsbaugruppe, insbesondere einer Bus-Eingangsbaugruppe, integriert, welche z.B. auch Teil eines Masters, einer sicheren Steuerung und/oder einer Feldeinheit sein kann. Die erfindungsgemäße Schaltung kann jedoch ferner auch zum Erfassen von Standard-Signalen, insbesondere wenn erhöhte Anforderungen bestehen, verwendet werden.

## Patentansprüche

1. Eingangsschaltung für eine Eingangsbaugruppe zum sicheren Einlesen von an der Eingangsbaugruppe anliegenden Eingangssignalen umfassend wenigstens einen Signaleingangsschaltkreis (110) mit einkanaligem Peripherieanschluss (INO) zum Anschließen wenigstens eines Signalgebers, einen mit dem Signaleingangsschaltkreis (110) über ein erstes Koppelglied (IC1) elektrisch anschaltbaren Auswertekreis (120) und einen mit dem Signaleingangsschaltkreis (110) elektrisch verbundenen Schaltkreis (200) zum Einstellen einer Referenzspannung zum Aktivieren und Deaktivieren des Koppelgliedes (IC1) , **dadurch gekennzeichnet, dass** der Schaltkreis (200) eine Referenzspannungsquelle (210) und eine Schaltung (220) zum Testen der Referenzspannungsquelle umfasst, wobei die Schaltung zum Testen der Referenzspannungsquelle (220) zwei, aus drei Widerständen (R21, R22, R23) aufgebaute, an einer Referenzdiode (IC23) angeschaltete Spannungsteiler zum Einstellen der Referenzspannung aufweist, wobei jeder der Spannungsteiler (R21; R22, R23) an ein jeweiliges zweites Koppelglied (IC21, IC22) zum jeweils individuellen Aufprägen eines Stromflusses angeschlossen ist, wobei die Eingangsschaltung eine mit dem Signaleingangsschaltkreiskreis elektrisch verbundene Testschaltung (300) zum Testen des ersten Koppelgliedes (IC1) umfasst und wobei die Testschaltung (300) zum Testen des ersten Koppelgliedes (IC1) ein drittes Koppelglied (IC3) aufweist, über welches eine Testspannung an das erste Koppelglied in dem Signaleingangsschaltkreis anlegbar ist.

2. Eingangsschaltung nach Anspruch 1, ferner **dadurch gekennzeichnet, dass** die Referenzdiode (IC23) an eine Versorgungsspannung (US1) angeschaltet ist, und zur Begrenzung der Versorgungsspannung ein im Leiter zwischen Referenzdiode und Versorgungsspannung angeordneter Widerstand (R24) und eine parallel zur Referenzdiode geschaltete Z-Diode (D2) vorgesehen sind.

3. Eingangsschaltung nach einem der vorstehenden Ansprüche, ferner **gekennzeichnet durch** eine im Signaleingangschaltkreis geschaltete Z-Diode (D1) zur Begrenzung der auf einem anliegenden Eingangssignal basierenden Eingangsspannung auf einen Maximalwert.

4. Eingangsschaltung nach einem der vorstehenden Ansprüche, ferner **dadurch gekennzeichnet, dass** wenigstens das erste Koppelglied (IC1) ein Optokoppler ist, vorzugsweise alle Koppelglieder Optokoppler sind.

5. Eingangsschaltung nach einem der vorstehenden Ansprüche, ferner **dadurch gekennzeichnet, dass** der Auswertekreis (120) zweikanalig aufgebaut ist.

6. Eingangsschaltung nach einem der vorstehenden Ansprüche, **dadurch gekennzeichnet, dass** redundante Signalgeber in Reihe an den Signaleingangsschaltkreis schaltbar sind.

7. Eingangsschaltung nach einem der vorstehenden Ansprüche, ferner **dadurch gekennzeichnet, dass** eine Vielzahl von Signaleingangsschaltkreisen an den Vergleichsschaltkreis parallel anschaltbar ist.

8. Eingangsschaltung nach einem der vorstehenden Ansprüche, ferner **dadurch gekennzeichnet, dass** die Eingangsbaugruppe eine Bus-Eingangsbaugruppe ist.

9. Eingangsbaugruppe umfassend eine Eingangsschaltung nach einem der vorstehenden Ansprüche.

10. Eingangsbaugruppe nach vorstehendem Anspruch, welche als Teil eines Masters, einer sicheren Steuerung und/oder einer Feldeinheit ausgebildet ist.

11. Eingangsbaugruppe nach einem der beiden vorstehenden Ansprüche, ferner **dadurch gekennzeichnet, dass** die Eingangsbaugruppe eine Bus-Eingangsbaugruppe ist.

12. Verwendung einer Eingangsschaltung nach einem der vorstehenden Ansprüche in der Sicherheitstechnik.

## Claims

1. Input circuit for an input assembly for safe reading-in of input signals applied to the input assembly
comprising
at least one signal input circuit (110) with a single-channel peripheral connection (INO) for connection of at least one signal generator, an evaluation circuit (12) which can be electrically connected to the signal input circuit (110) via a first coupling member (IC1), and a circuit (200), which is electrically connected to the signal input circuit (110), for adjusting a reference voltage for activation and deactivation of the coupling member (IC1),
**characterised in that**
the circuit (200) has a reference voltage source (210) and a circuit (220) for testing the reference voltage source, wherein the circuit for testing the reference voltage source (220) has two voltage dividers, which are assembled from three resistors (R21, R22, R23) and connected to a reference diode (IC23), for adjusting the reference voltage, wherein each of the voltage dividers (R21; R22, R23) is connected to a respective second coupling member (IC21, IC22) for individually impressing a current flow in each case, wherein the input circuit has a test circuit (300), which is electrically connected to the signal input circuit, for testing the first coupling member (IC1) and wherein the test circuit (300) for testing the first coupling member (IC1) has a third coupling member (IC3) via which a test voltage can be applied to the first coupling member in the signal input circuit.

2. Input circuit as claimed in claim 1, further **characterised in that** the reference diode (IC23) is connected to a supply voltage (US1), and, in order to limit the supply voltage, a resistor (R24), disposed in the conductor between the reference diode and the supply voltage, and a Z-diode (D2), connected in parallel with the reference diode, are provided.

3. Input circuit as claimed in any one of the preceding claims, further **characterised by** a Z-diode (D1), connected in the signal input circuit, in order to limit the input voltage, based on the applied input signal, to a maximum value.

4. Input circuit as claimed in any one of the preceding claims, further **characterised in that** at least the first coupling member (IC1) is an optical coupling device, preferably all coupling members are optical coupling devices.

5. Input circuit as claimed in any one of the preceding claims, further **characterised in that** the evaluation circuit (120) is constructed with two channels.

6. Input circuit as claimed in any one of the preceding claims, **characterised in that** redundant signal generators can be connected in series to the signal input circuit.

7. Input circuit as claimed in any one of the preceding claims, further **characterised in that** a plurality of signal input circuits can be connected in parallel to the comparison circuit.

8. Input circuit as claimed in any one of the preceding claims, further **characterised in that** the input assembly is a bus input assembly.

9. Input assembly comprising an input circuit as claimed in any one of the preceding claims.

10. Input assembly as claimed in the preceding claim, which is formed as part of a master, of a safe control and/or of a field unit.

11. Input assembly as claimed in one of the two preceding claims, further **characterised in that** the input assembly is a bus input assembly.

12. Use of an input circuit as claimed in any one of the preceding claims in safety technology.

## Revendications

1. Circuit d'entrée destiné à un ensemble d'entrée pour une lecture sûre de signaux d'entrée s'appliquant sur l'ensemble d'entrée,
comprenant au moins circuit d'entrée de signal (110) avec branchement de périphérie monocanal (INO) pour le raccordement d'au moins un générateur de signal, un circuit d'analyse (120) pouvant être connecté électriquement au circuit d'entrée de signal (110) par un premier élément de couplage (IC1), et un circuit de commutation (200) relié électriquement au circuit d'entrée de signal (110) pour le réglage d'une tension de référence pour l'activation et la désactivation de l'élément de couplage (IC1),
**caractérisé en ce que** le circuit de commutation (200) comprend une source de tension de référence (210) et un circuit (220) pour tester la source de tension de référence, le circuit pour tester la source de tension de référence (220) présentant deux diviseurs de tension constitués de trois résistances (R21, R22, R23) et connectés à une diode de référence (IC23) pour le réglage de la tension de référence, chacun des diviseurs de tension (R21 ; R22, R23) étant raccordé à un second élément de couplage respectif (IC21, IC22) pour l'application respectivement individuelle d'un flux de courant, le circuit d'entrée comprenant un circuit de test (300) relié électriquement au circuit d'entrée de signal pour tester le premier élément de couplage (IC1) et le circuit de test (300) pour le test du premier élément de couplage (IC1) présentant un troisième élément de couplage (IC3) par lequel une tension de test peut être appliquée sur le premier élément de couplage dans le circuit d'entrée de signal.

2. Circuit d'entrée selon la revendication 1, caractérisé également en ce que la diode de référence (IC23) est connectée à une tension d'alimentation (US1), et une résistance (R24), disposée dans le conducteur entre la diode de référence et la tension d'alimentation, et une diode Z (D2) connectée en parallèle à la diode de référence étant prévues pour limiter la tension d'alimentation.

3. Circuit d'entrée selon l'une quelconque des revendications précédentes, caractérisé également par une diode Z (D1) montée dans le circuit d'entrée de signal pour limiter à une valeur maximale la tension d'entrée basée sur un signal d'entrée appliqué.

4. Circuit d'entrée selon l'une quelconque des revendications précédentes, caractérisé également en ce qu'au moins le premier élément de couplage (IC1) est un optocoupleur, de préférence tous les éléments de couplage sont des optocoupleurs.

5. Circuit d'entrée selon l'une quelconque des revendications précédentes, caractérisé également en ce que le circuit d'analyse (120) est conçu avec deux canaux.

6. Circuit d'entrée selon l'une quelconque des revendications précédentes, caractérisé également en ce que des générateurs de signaux redondants peuvent être montés en série avec le circuit d'entrée de signal.

7. Circuit d'entrée selon l'une quelconque des revendications précédentes, caractérisé également en ce qu'une pluralité de circuits d'entrée de signal peut être connectée en parallèle au circuit de comparaison.

8. Circuit d'entrée selon l'une quelconque des revendications précédentes, caractérisé également en ce que l'ensemble d'entrée est un ensemble d'entré de bus.

9. Ensemble d'entrée comprenant un circuit d'entrée selon l'une quelconque des revendications précédentes.

10. Ensemble d'entrée selon la revendication précédente, qui est conçu comme une partie d'un maître, d'une commande sûre et/ou d'une unité de champ.

11. Ensemble d'entrée selon l'une des deux revendications précédentes, l'ensemble d'entrée étant caractérisé également en ce qu'il est un ensemble d'entrée de bus.

12. Utilisation d'un circuit d'entrée selon l'une quelconque des revendications précédentes dans la technique de sécurité.
